# EUROPEAN PATENT APPLICATION

(11) **EP 4 678 783 A1**
(43) Date of publication of application: **14.01.2026**
(21) Application number: 23956815.7
(22) Date of filing: 26.10.2023
(51) Int. Cl.: C23C 14/50, C23C 16/44, H01L 21/683

(54) **VACUUM TREATMENT DEVICE, ELECTROSTATIC CHUCK, AND TRANSPORT ROLLER**

(71) Applicant: ULVAC, Inc., Chigasaki-shi, Kanagawa 253-8543 (JP)
(72) Inventor: KIKUCHI, Toru, Chigasaki-shi, Kanagawa 253-8543 (JP); MAEHIRA, Ken, Chigasaki-shi, Kanagawa 253-8543 (JP); KOYAMA, Koichi, Chigasaki-shi, Kanagawa 253-8543 (JP); HASHIMOTO, Yusuke, Chigasaki-shi, Kanagawa 253-8543 (JP); FUJIMOTO, Shinya, Chigasaki-shi, Kanagawa 253-8543 (JP); NAKAMURA, Shintaroh, Chigasaki-shi, Kanagawa 253-8543 (JP)
(74) Representative: Lorenz & Kollegen
(86) International application number: PCT/JP2023/038761
(87) International publication number: WO 2025/088764

(57) **Abstract**

A vacuum treatment apparatus according to an embodiment of the present invention includes a vacuum chamber, a support, and a surface treatment means. The support includes a base part and a surface layer. The base part is disposed inside the vacuum chamber and constituted by a conductor. The surface layer is constituted by a dielectric and covers a surface of the base part. The surface layer includes a support surface that electrostatically attracts a base that is a treatment target. The surface treatment means treats a surface of the base attracted to the support surface. The surface layer has a thickness of 200 µm or more and 800 µm or less, and the support surface has surface roughness (Ra) of 0.06 µm or more and 0.2 µm or less and a profile bearing length ratio at a section level of 50% or more is 90% or more.

## Description

### Technical Field

The present invention relates to a vacuum treatment apparatus, such as a roll-to-roll deposition apparatus, and to an electrostatic chuck and a conveyance roller that are used therefor.

### Background Art

Conventionally, a vacuum vapor deposition apparatus that winds a long raw material film continuously fed from a feed roller around a cooling roller while vapor-depositing an evaporated material from an evaporation source disposed facing the cooling roller onto a raw material film and takes up the vapor-deposited raw material film by a take-up roller is known. This type of vacuum vapor deposition apparatus performs coating deposition treatment while cooling the raw material film made to adhere to the circumferential surface of the cooling roller to prevent thermal deformation of the raw material film during vapor deposition. Therefore, how to ensure the adhesive effect between the raw material film and the cooling roller is a key problem.

As a configuration for increasing the adhesive force between the raw material film and the cooling roller, for example, Patent Literature 1 below has disclosed a technology for increasing the adhesive effect between the raw material film and the cooling roller, in which an auxiliary roller that is held in contact with a metal coating vapor-deposited on a coating deposition surface of a raw material film is disposed between the cooling roller and a take-up part that takes up the raw material film and a direct-current (DC) voltage is applied between the cooling roller and the auxiliary roller to generate an electrostatic attractive force between the metal coating on the raw material film and the cooling roller.

Also, Patent Literature 2 below has disclosed a technology related to an insulator layer that is formed on a surface of a cooling roller in a technology of forming metal coatings on both surfaces of a raw material film, using an electrostatic attraction effect between the cooling roller and the raw material film.

### Citation List

### Patent Literature

Patent Literature 1: Japanese Patent No. 3795518
Patent Literature 2: Japanese Patent No. 5481239

### Disclosure of Invention

### Technical Problem

The deposition method using the electrostatic attraction effect between the cooling roller and the raw material film has a problem on dielectric strength therebetween. For example, since an insulation layer provided on the outer circumferential surface of the cooling roller is typically formed by thermal spraying, if electrical discharge occurs at a site where the thermally sprayed coating has lower dielectric strength, the adhesive force of the raw material film located at this site may be lower and significantly damaged by heat from the evaporation source.

Moreover, one of possible methods for increasing the dielectric strength between the cooling roller and the raw material film is increasing the thickness of the insulation layer on the cooling roller surface. However, the thermally sprayed coating may be more fragile along with the increase in the thickness of the insulation layer, and the attractive force may decrease due to cracking, peeling, or the like.

Note that such a problem is not only to roll-to-roll vacuum treatment apparatuses, but also to electrostatic chucks that are applied to stages for supporting substrates, e.g., semiconductor wafers and glass substrates, when coatings are deposited on these substrates. A structure that circulates a cooling gas, e.g., He, between a surface of an electrostatic chuck and a back surface of a substrate is known for this type of stage. In this case, if electrical breakdown occurs in an insulation layer of the electrostatic chuck that supports the back surface of the substrate, it is highly likely to decrease the adhesive force between the stage and the substrate.

In view of the above-mentioned circumstances, it is an objective of the present invention to provide a vacuum treatment apparatus, an electrostatic chuck, and a conveyance roller that are capable of achieving both attractive force and dielectric strength. Solution to Problem

A vacuum treatment apparatus according to an embodiment of the present invention includes a vacuum chamber, a support, and a surface treatment means.

The support includes a base part and a surface layer. The base part is disposed inside the vacuum chamber and constituted by a conductor. The surface layer is constituted by a dielectric and covers a surface of the base part. The surface layer includes a support surface that electrostatically attracts a base that is a treatment target.

The surface treatment means treats a surface of the base attracted to the support surface.

The surface layer has a thickness of 200 µm or more and 800 µm or less, and the support surface has surface roughness (Ra) of 0.06 µm or more and 0.2 µm or less and a profile bearing length ratio at a section level of 50% or more is 90% or more.

In the present invention, making settings so that the surface layer has a thickness of 200 µm or more and 800 µm or less, and the support surface has surface roughness (Ra) of 0.06 µm or more and 0.2 µm or less and a profile bearing length ratio at a section level of 50% or more is 90% or more increases the adhesive force between the base and the surface layer of the support. This can achieve both attractive force and dielectric strength. Moreover, the increase in the adhesive force between the base and the surface layer also increases the heat transfer efficiency therebetween. This can suppress thermal deformation of the base.

The surface layer may have a thickness of 400 µm or more and 600 µm or less. This can increase the dielectric strength of the surface layer.

The surface layer may be an aluminum oxide containing a titanium oxide. Carbon, SiC, or the like may replace the titanium oxide. Otherwise, PBN, SiN, Al₂O₃, ZrO, MgO, SiO, CrO, CaO, AlN, or the like may be used as the dielectric that constitutes the surface layer.

A long film can be employed as the base. In this case, the support may be at least one conveyance that conveys the base with the base wound around the roller.

This can continuously perform surface treatment on the base in a longitudinal direction of the base.

Alternatively, a semiconductor substrate or a glass substrate can be employed as the base. In this case, the support may be a stage on which the base is placed.

The vacuum treatment apparatus may further include a first voltage supply circuit. The first voltage supply circuit includes an auxiliary roller that is disposed on a downstream side or upstream side of the conveyance roller and is held in contact with one main surface of the base and a voltage source for applying a direct-current (DC) voltage between the auxiliary roller and the conveyance roller. In this case, the surface treatment means may include a first coating deposition unit that vapor-deposits a conductive material on the one main surface of the base.

Alternatively, the vacuum treatment apparatus may further include a second voltage supply circuit. The second voltage supply circuit includes an auxiliary roller that is disposed on an upstream side or downstream side of the conveyance roller and is held in contact with one surface of the base on which a conductive material is deposited, and a voltage source for applying a direct-current (DC) voltage between the auxiliary roller and the conveyance roller. In this case, the surface treatment means may include a second coating deposition unit that vapor-deposits a conductive material on another main surface of the base.

The vacuum treatment apparatus may further include a neutralization unit that irradiates the base or the conveyance roller with charged particles for neutralizing the base. This suppresses peeling electrification of the base from the conveyance roller. Therefore, it can effectively suppress electrical discharge when the base is peeled from the conveyance roller.

An electrostatic chuck according to an embodiment of the present invention includes a base part and a surface layer.

The base part is constituted by a conductor.

The surface layer is constituted by a dielectric, covers a surface of the base part, and includes a support surface that electrostatically attracts a base that is a treatment target.

The surface layer has a thickness of 200 µm or more and 800 µm or less, and the support surface has surface roughness (Ra) of 0.06 µm or more and 0.2 µm or less and a profile bearing length ratio at a section level of 50% or more is 90% or more.

A conveyance roller according to an embodiment of the present invention includes a rotatable tubular base part and a surface layer.

The base part is constituted by a conductor.

The surface layer is constituted by a dielectric, covers a surface of the base part, and includes a support surface that electrostatically attracts a long film that is a treatment target.

The surface layer has a thickness of 200 µm or more and 800 µm or less, and the support surface has surface roughness (Ra) of 0.06 µm or more and 0.2 µm or less and a profile bearing length ratio at a section level of 50% or more is 90% or more.

### Advantageous Effects of Invention

In accordance with the present invention, both attractive force and dielectric strength can be achieved.

### Brief Description of Drawings

[Fig. 1] A schematic configuration view of a vacuum treatment apparatus according to a first embodiment of the present invention.
[Fig. 2] A cross-sectional view of main parts of a support (conveyance roller) in the vacuum treatment apparatus in Fig. 1.
[Fig. 3] An enlarged cross-sectional view of the A-section in Fig. 2.
[Fig. 4] A schematic view describing an electrostatic chuck mechanism that generates an electrostatic attractive force for a film.
[Fig. 5] A diagram describing a relationship between a thickness of a dielectric layer and an attractive force in the electrostatic chuck mechanism.
[Fig. 6] A diagram describing a relationship between the thickness of the dielectric layer and the magnitude of a leakage current in the electrostatic chuck mechanism.
[Fig. 7] Experimental results of measuring a surface potential of a film where a metal coating with a thickness of 1 µm is deposited.
[Fig. 8] A schematic configuration view of a vacuum treatment apparatus according to a second embodiment of the present invention.
[Fig. 9] A schematic view of an electrostatic chuck mechanism configured between each of first conveyance roller and second conveyance roller and a film in the vacuum treatment apparatus in Fig. 8.
[Fig. 10] A schematic cross-sectional view showing a modified example of a configuration of a surface layer in Fig. 3.

### Mode(s) for Carrying Out the Invention

Hereinafter, embodiments of the present invention will be described with reference to the drawings.

### <First Embodiment>

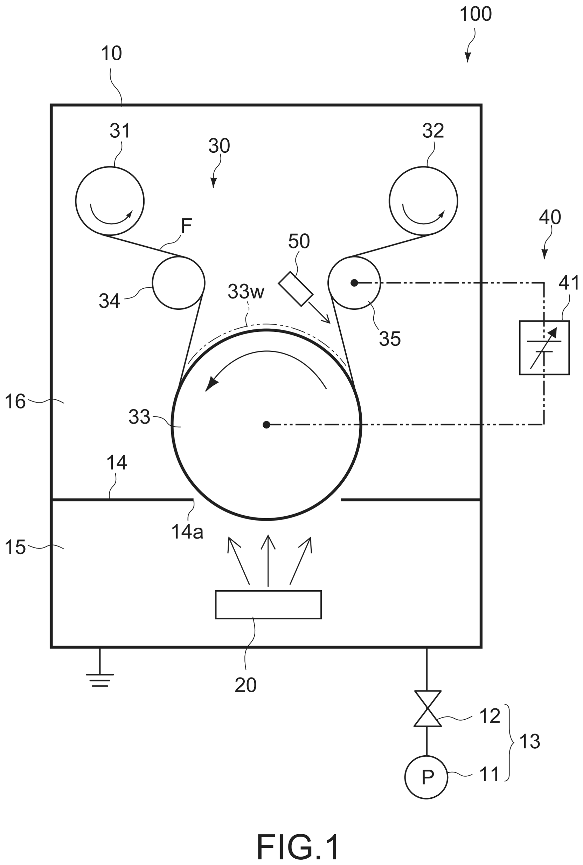

Fig. 1 is a schematic configuration view of a vacuum treatment apparatus 100 according to a first embodiment of the present invention. The vacuum treatment apparatus 100 according to this embodiment is configured as a roll-to-roll vacuum vapor deposition apparatus.

### [Overall Configuration]

The vacuum treatment apparatus 100 according to this embodiment includes a vacuum chamber 10, a coating deposition unit 20, a film conveying part 30, a voltage supply circuit 40, and a neutralization unit 50.

The vacuum chamber 10 is a hermetically sealed container made of metal and is connected to ground potential. The vacuum chamber 10 is connected to an evacuation line 13 including a vacuum pump 11 and a vacuum valve 12. The inside of the vacuum chamber 10 is configured to be capable of being evacuated or maintained at a predetermined pressure-reduced atmosphere through the evacuation line 13. The vacuum chamber 100 houses the coating deposition unit 20 and the film conveying part 30. A partition plate 14 is provided inside the vacuum chamber 100. The partition plate 14 divides the inside of the vacuum chamber 100 into a coating deposition chamber 15 and a conveyance chamber 16.

The coating deposition unit 20 is disposed inside the coating deposition chamber 15. In this embodiment, the coating deposition unit 20 is an evaporation source that evaporates any evaporation material. The coating deposition unit 20 is a specific example of a surface treatment means that treats a surface of a film F attracted to a main roller 33 of the film conveying part 30.

The coating deposition unit 20 includes a heating mechanism that heats the evaporation material. Any heating mechanism, e.g., resistance heating, induction heating, or electronic beam heating, can also be employed as the heating mechanism. For example, the evaporation material is typically a metal, such as aluminum, copper, lithium, tin, or zinc, or an alloy, oxide, nitride, or fluoride of these metals.

The film conveying part 30 is disposed inside the conveyance chamber 16. The film conveying part 30 includes a feed roller 31 that continuously feeds the film F, which is a base, a take-up roller 32 that continuously takes up the film F fed from the feed roller 31, and the main roller 33 (conveyance roller) placed on a film conveying path between the feed roller 31 and the take-up roller 32. The film conveying part 30 further includes a first auxiliary roller 34 and a second auxiliary roller 35. The first auxiliary roller 34 and the second auxiliary roller 35 are made of metal. The first auxiliary roller 34 is disposed on the upstream side of the main roller 33. The second auxiliary roller 35 is disposed on the downstream side of the main roller 33.

Each of the feed roller 31, the take-up roller 32, and the main roller 33 includes a rotation drive unit (not shown) and is configured to rotate at a predetermined speed in the direction of the arrow shown in the figure. Accordingly, the film F is conveyed at a predetermined conveyance speed to the take-up roller 32 from the feed roller 31 in the vacuum chamber 100. Note that each of the first auxiliary roller 34 and the second auxiliary roller 35 is constituted by a free roller without any rotation drive unit, though not limited thereto. Each of the first auxiliary roller 34 and the second auxiliary roller 35 may include a rotation drive unit.

At least a part of the main roller 33 faces the coating deposition unit 20 through an opening 14a formed in the partition plate 14. The film F is conveyed to the take-up roller 32 in a state of being wound around the outer circumferential surface of the main roller 33 at a predetermined wrap angle. Meanwhile, the coating deposition unit 20 deposits a coating on a surface region of the film F that is exposed to the coating deposition chamber 15 through the opening 14a. The film F is taken up by the take-up roller 32 while the coating is deposited to be continuous on the outer circumferential surface of the main roller 33.

The film F is an insulator, and is constituted by a resin film, such as an oriented polypropylene (OPP) film, a polyethylene terephthalate (PET) film, a polyphenylene sulfide (PPS) film, or a polyimide (PI) film.

Note that connecting a vacuum evacuation line 14 to the coating deposition chamber 15 causes a pressure difference between the coating deposition chamber 15 and the conveyance chamber 16 due to the presence of a partition wall 14 during evacuation. This pressure difference suppresses an evaporated flow of the evaporation material from entering the conveyance chamber 16 through the opening 14a.

The voltage supply circuit 40 includes a voltage source 41 that applies a predetermined direct-current (DC) voltage between the main roller 33 and the second auxiliary roller 35. In this embodiment, the voltage source 41 is constituted by a variable DC power supply. As a matter of course, a fixed power supply may replace the variable DC power supply. The voltage supply circuit 40 applies positive potential to the second auxiliary roller 35 and applies negative potential (ground potential) to the main roller 33, though not limited thereto. The voltage supply circuit 40 may apply positive potential to the main roller 33 and may apply negative potential to the second auxiliary roller 35. The voltage source 41 is placed outside the vacuum chamber 100.

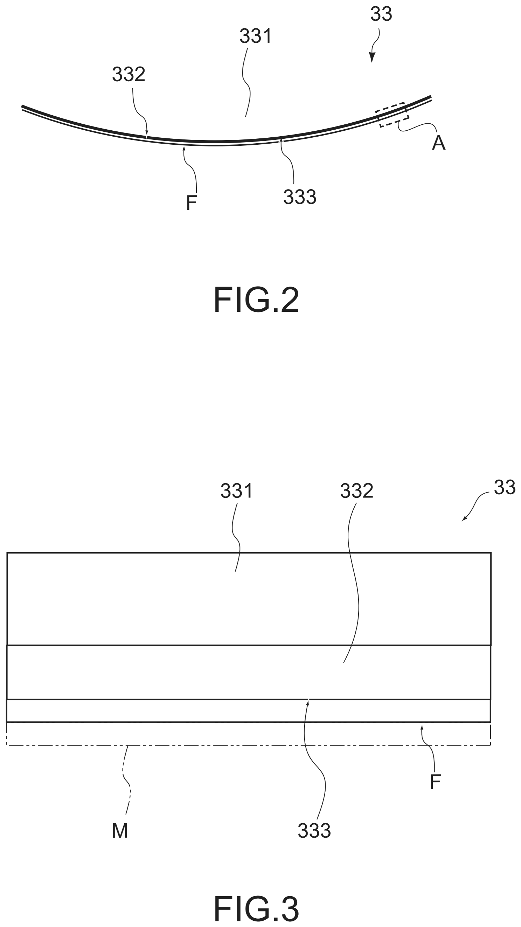

The second auxiliary roller 35 guides the film F to the take-up roller 32 while the second auxiliary roller 35 is held in contact with a coating deposition surface of the film F subjected to coating deposition treatment on the main roller 33. Therefore, the second auxiliary roller 35 is held in contact with a metal coating M (see Fig. 3) deposited on the coating deposition surface of the film F. Tehrefore, a DC voltage from the voltage source 41 is input between the main roller 33 and the metal coating M on the film F supported on the outer circumferential surface of the main roller 33. Accordingly, the film F is attracted by the outer circumferential surface of the main roller 33 by an electrostatic force generated between the main roller 33 and the metal coating M.

The neutralization unit 50 is for suppressing electrification of the film F or electrification (peeling electrification) of the main roller 33, which occurs when the film F is peeled from the main roller 33. The neutralization unit 50 is configured to be capable of radiating charged particles for neutralization to the film F or the main roller 33. In this embodiment, the neutralization unit 50 is constituted by an ion irradiator that is disposed directly above the main roller 33 and radiates positive ions, e.g., argon ions, to a non-coating deposition surface of the film F, which is peeled from the main roller 33, though not limited thereto. The neutralization unit 50 may be configured to directly radiate charged particles for neutralization to a partial region (region 33w indicated by the long dashed double-short dashed line in Fig. 1) of the outer circumferential surface of the main roller 33, around which the film F is not wound.

### [Details of Main Roller]

Subsequently, details of the main roller 33 will be described. Fig. 2 is a cross-sectional view of main parts of the main roller 33. Fig. 3 is an enlarged cross-sectional view of the A-section in Fig. 2.

The main roller 33 is configured as a support for the film F, which is a base that is a treatment target in the vacuum treatment apparatus 100. The main roller 33 includes a base part 331 and a surface layer 332. The base part 331 has a cylindrical shape or columnar shape and is constituted by an conductive material. The surface layer 332 covers an outer surface of the base part 331.

The base part 331 is constituted by a metal material, e.g., stainless steel, iron, or aluminum. A temperature control unit (not shown), such as a temperature control medium circulation system, may be provided inside the base part 331. An organic medium having a high boiling point, such as silicone oil, can be used as a heating medium to be circulated in the temperature control unit. Water can be used as a refrigerant. The size of the base part 331 is not particularly limited. Typically, an axial width dimension of the base part 331 is set to be larger than a width dimension of the film F.

In this embodiment, a resin film is used as the film F. Therefore, in order to prevent the film F from being deformed by heat radiation from the coating deposition unit 20 or sensible heat or latent heat of the deposited coating (metal coating M), the film F is cooled at a predetermined temperature or less by circulating the refrigerant through the base part 331 so that fine lines are not formed due to thermal deformation. The main roller 33 thus functions as a cooling roller.

The surface layer 332 is constituted by a dielectric. In this embodiment, the surface layer 332 is a thermally sprayed coating formed on an outer circumferential surface of the base part 331. The surface layer 332 includes a support surface 333 that electrostatically attracts the film F. That is, in this embodiment, the main roller 33 functions as an electrostatic chuck that makes the support surface 333 electrostatically attract the film F.

For example, several types of electrostatic attraction effects dominated by coulombic force, Johnsen-Rahbek force, and gradient force are used for the electrostatic chuck. The electrostatic chuck dominated by the coulombic force is designed to be capable of attracting a target object by applying a high voltage. The electrostatic chuck dominated by the Johnsen-Rahbek force is designed to attract a target object by adjusting the insulation of the dielectric layer to allow a small amount of current to flow through the dielectric layer. The electrostatic chuck dominated by the gradient force is designed to attract using an electric field generated between both polarities by alternately arranging positive and negative electrodes in a fine pattern. These electrostatic chucks are selected depending on conditions, such as characteristics, kind, and use environment of a target object. For example, the coulombic type is employed in a case where the target object is an conductive object or a semiconductor. For example, the Johnsen-Rahbek type or gradient type is employed in a case where the target object is an insulative object or a semiconductor.

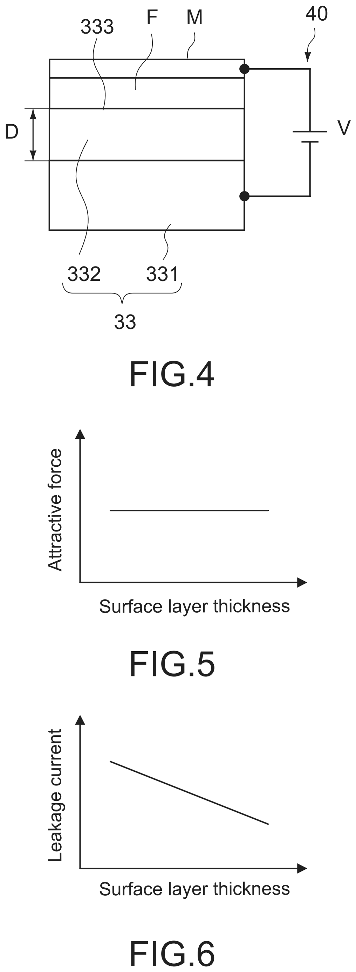

Fig. 4 is a schematic view describing an electrostatic chuck mechanism that generates an electrostatic attractive force for the film F. As shown in the figure, the film F is supported on the support surface 333 by an electrostatic attractive force depending on the magnitude of a DC voltage V from the voltage source 41 input between the metal coating M formed on the coating deposition surface of the film F and the base part 331 of the main roller 33. The magnitude of the DC voltage V during coating deposition is 500 V, for example.

In this embodiment, an aluminum oxide containing a titanium oxide is used as the dielectric that constitutes the surface layer 332. The titanium oxide content is 5 to 15 wt%, for example. Carbon, SiC, or the like may replace the titanium oxide. Otherwise, PBN, SiN, Al₂O₃, ZrO, MgO, SiO, CrO, CaO, AlN, or the like may be used as the dielectric that constitutes the surface layer.

Here, a deposition method using an electrostatic attraction effect between a cooling roller and a raw material film has a problem on dielectric strength therebetween. For example, if electrical discharge occurs at a low-dielectric strength site of the insulation layer provided on an outer circumferential surface of the cooling roller, the adhesive force of the raw material film at that site may decrease and may be significantly damaged by heat from the evaporation source.

To overcome such a problem, in this embodiment, the surface layer 332 is configured so that surface roughness (Ra) of the support surface 333 is 0.06 µm or more and 0.2 µµm or less and that a profile bearing length ratio (tp) at a section level of 50% or more is 90% or more. Accordingly, since the contact area between the film F and the support surface 333 increases, the adhesive force of the film F to the support surface 333 increases. It is thus possible to improve the attractive force.

Since the film F and the support surface 333 are in contact with each other in a solid state, their contact area does not necessarily increase only by reducing the surface roughness of the support surface 333 to a predetermined level or less. Therefore, in this embodiment, the profile bearing length ratio at the section level of 50% or more is defined and the support surface 333 is adjusted so that the profile bearing length ratio is 90% or more. Accordingly, the heat transfer coefficient between the film F and the support surface 333 when a DC voltage is 100 V or more can be set to be about 1000 W (m²*K) or more, and it is possible to effectively protect the film F from thermal deformation.

The profile bearing length ratio (tp) represents, as a percentage, a ratio of a sum of cut lengths (bearing length np) to an evaluation length, the cut lengths (bearing length np) being obtained when extracting a section from a roughness curve in its mean line direction by the evaluation length and slicing the roughness curve in the extracted section at a section level parallel to the profile peak line. In this embodiment, the profile bearing length ratio at the section level of 50% is set to 90% or more, and more favorably, the profile bearing length ratio at the section level of 60% is set to 95% or more, and still more favorably, the profile bearing length ratio at the section level of 70% is set to 98% or more.

Note that in this embodiment, the values of the surface roughness (Ra) and the profile bearing length ratio (tp) were measured using a surface roughness meter "Controller VK-9500/Measuring Instrument 9510" manufactured by Keyence Corporation.

The method of obtaining the support surface 333 having the surface roughness (Ra) and the profile bearing length ratio (p) is not particularly limited. Typically, after rough grinding using a double-sided lapping machine with free abrasive grains, the thermally sprayed coating is processed in the order of medium grinding and finish grinding. Specifically, as finishing grinding, for example, grinding abrasive grains with a grain size of about #1000 to #2000 are used to remove only the protruding parts (mountain tops) of the surface. Chemical grinding may be used in combination as necessary. Moreover, the processing direction and processing pressure may be adjusted in stages. Such a processing method can provide the support surface 333 having the above-mentioned predetermined surface roughness (Ra) and profile bearing length ratio (tp).

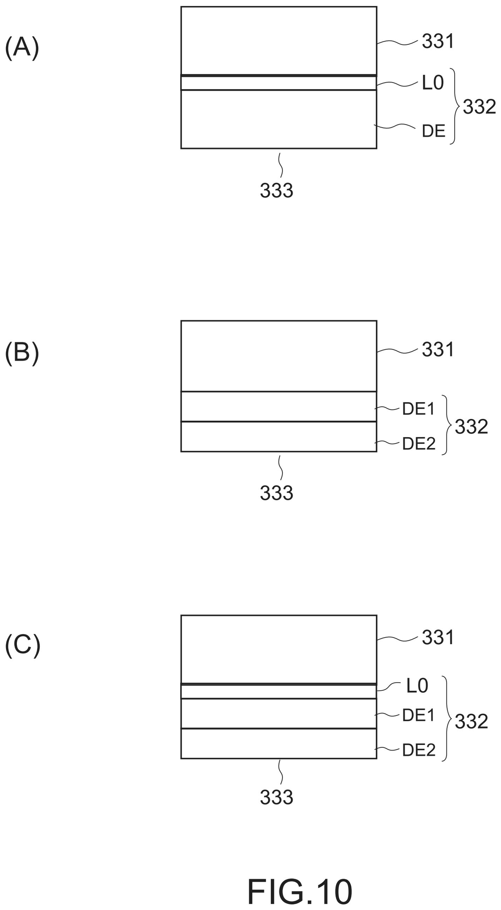

Note that the surface layer 332 may have a multi-layer structure with two or more layers. For example, as shown in (A) of Fig. 10, the surface layer 332 may be constituted by a bonding layer L0 formed on the surface of the base part 331 and a dielectric layer DE formed on the bonding layer L0. For example, the bonding layer L0 is a nickel aluminum alloy, and can be formed by thermal spraying as in the dielectric layer DE.

Moreover, as shown in (B) of Fig. 10, the surface layer 332 may be a laminate of a first dielectric layer DE1 and a second dielectric layer DE2. The first dielectric layer DE1 and the second dielectric layer DE2 are typically constituted by different materials or different component ratios. To increase the attractive force, the second dielectric layer DE2 on the outermost layer side that forms the support surface 333 is favorably made of a material having conductivity higher than that of the first dielectric layer DE1, for example. The dielectric layer is not limited to the two layers, and may be three or more layers. Moreover, as shown in (C) of Fig. 10, the surface layer 322 contain the bonding layer L0 formed between the base part 331 and the first dielectric layer DE1.

The support surface 333 is not limited to the example in which it is constituted by the dielectric that constitutes the surface layer 332. A part of the support surface 333 or the entire support surface 333 may be constituted by a different dielectric. In this case, for example, the following method can be applied: a dielectric to form the support surface 333 is applied onto the surface of the surface layer 332 and a finishing grinding process is performed; or such a dielectric is applied in a finishing grinding process for the surface of the surface layer 332.

In this embodiment, since the film F is attracted by the electrostatic attraction of the electric charge accumulated on the support surface 333, in principle, a constant attractive force is obtained regardless of a thickness D (see Fig. 4) of the surface layer which is a dielectric layer as shown in Fig. 5. Moreover, as shown in Fig. 6, the greater the thickness D of the surface layer 332, the smaller the leakage current between the film F and the main roller 33 can be made. Therefore, increasing the thickness of the surface layer 332 can increase the dielectric strength of the surface layer 332.

However, since the surface layer 332 is a thermally sprayed coating, the surface layer 332 may be more fragile along with the increase in the thickness D of the surface layer 322, and the attractive force may decrease due to cracking, peeling, or the like. Therefore, the thickness D of the surface layer 322 is favorably 200 µm or more and 800 µm or less, more favorably 250 µm or more and 700 µm or less, and still more favorably, 400 µm or more and 600 µm or less.

The inventors of the present invention conducted acceleration tests for the dielectric strength by preparing four types of samples with thicknesses D of 200 µm, 400 µm, 600 µm, and 800 µm as dielectric layers having the same configuration as the surface layer 322. The applied voltage was set to 0.32 kV to 5 kV. The experimental results are shown in Table 1.

As shown in Table 1, electrical breakdown was observed at an applied voltage of 2 kV in the sample with a thickness of 200 µm and electrical breakdown was observed at an applied voltage of 3.5 kV in the sample with a thickness of 400 µm. Note that no electrical breakdown was observed in the sample with a thickness of 600 µm and 800 µm. Since the magnitude of the DC voltage V input during coating deposition can be 500V, for example, the thickness D of the surface layer 322 in this case is favorably at least 200 µm or more and 800 µm or less.

**[Table 1]**

| AlO/TiO | Layer thickness (*µ*m) | 200 | 400 | 600 | 800 |
|---|---|---|---|---|---|
| | 0.32 | ○ | ○ | ○ | ○ |
| | 0.5 | ○ | ○ | ○ | ○ |
| | 1 | ○ | ○ | ○ | ○ |
| Applied voltage (kV) | 1.5 | ○ | ○ | ○ | ○ |
| | 2 | × | ○ | ○ | ○ |
| | 3 | | ○ | ○ | ○ |
| | 3.5 | | × | ○ | ○ |
| | 4 | | | ○ | ○ |
| | 5 | | | ○ | ○ |

As described above, in accordance with this embodiment, the above-mentioned configuration of the surface layer 332 of the main roller 33 increases the adhesive force between the film F and the support surface 333 of the main roller 33. This can achieve both attractive force and dielectric strength. Moreover, the increase in the adhesive force between the film F and the support surface 333 also increases the heat transfer efficiency therebetween. This can suppress thermal deformation of the film F.

In addition, in accordance with this embodiment, the neutralization unit 50 that neutralizes the film F suppresses peeling electrification of the film F from the main roller 33. It can effectively suppress electrical discharge when the film F is peeled from the main roller 33. Accordingly, damage of a metal coating M1 or the support surface 333 of the main roller 33 due to the electrical discharge can be suppressed.

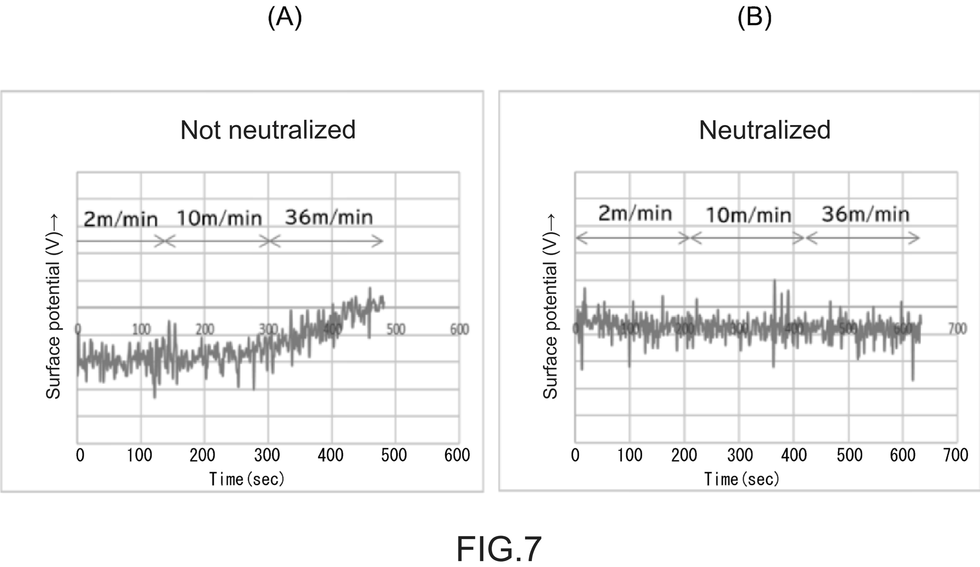

In particular, the peeling electrification are more frequently generated as the conveyance speed (or coating deposition rate) of the film F increases. Fig. 7 shows experimental results of measuring the potential of the surface of the film F when the metal coating M was deposited to have a thickness 1 µm. Without the neutralization unit, as shown in (A) of Fig. 7, the potential of the surface of the film F tends to increase along with an increase in the conveyance speed. Meanwhile, with the neutralization unit, as shown in (B) of Fig. 7, the surface potential can be maintained substantially constant regardless of the conveyance speed of the film F. In this manner, in accordance with this embodiment, it is also possible to sufficiently achieve an increase in the coating deposition speed, and it is possible to manufacture a film with a metal coating with high quality speedily and stably.

### <Second Embodiment>

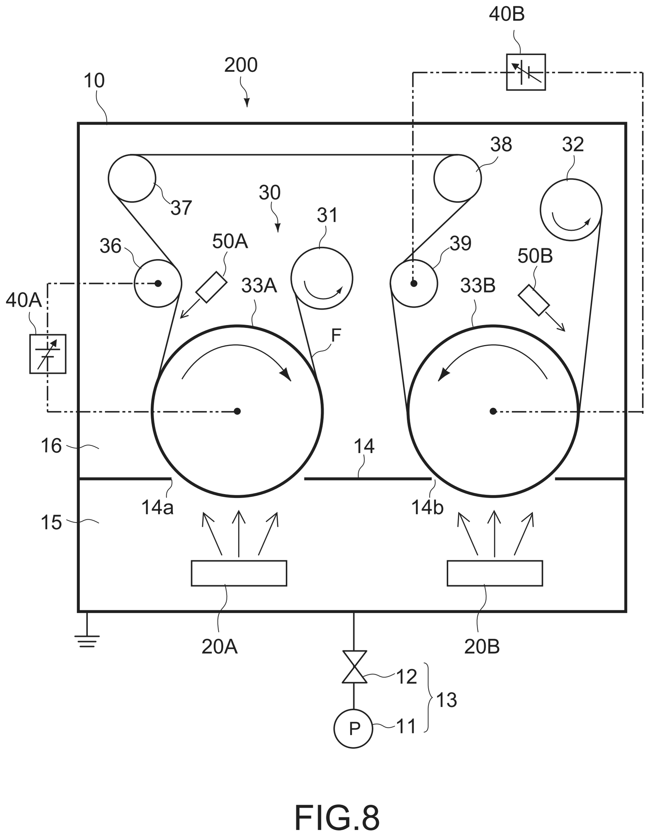

Fig. 8 is a schematic configuration view of a vacuum treatment apparatus 200 according to a second embodiment of the present invention. The vacuum treatment apparatus 200 according to this embodiment is configured as a roll-to-roll vacuum vapor deposition apparatus as in the first embodiment. Note that portions corresponding to the above-mentioned first embodiment are denoted by the same reference signs in the figure, and detailed descriptions thereof will be omitted or simplified.

The vacuum treatment apparatus 200 according to this embodiment includes a vacuum chamber 10, coating deposition units 20A and 20B, a film conveying part 30, voltage supply circuits 40A and 40B, and neutralization units 50A and 50B. The vacuum treatment apparatus 200 according to this embodiment is different from the first embodiment in that it is configured so that metal coatings are deposited on both surfaces of a film F. Hereinafter, differences from the first embodiment will be primarily described.

The conveying part 30 includes a feed roller 31, a take-up roller 32, and two main rollers (first and second conveyance rollers) 33A and 33B. The two main rollers (first and second conveyance rollers) 33A and 33B are provided on a film conveying path between the feed roller 31 and the take-up roller 32. Both the first main roller 33A and the second main roller 33B have the same configurations as the main roller 33 described in the first embodiment, so descriptions thereof will be omitted.

A first auxiliary roller 36, two guide rollers 37 and 38, and a second auxiliary roller 39 are disposed in the stated order on the film conveying path between the first main roller 33A and the second main roller 33B. The first auxiliary roller 36 is made of metal. The first auxiliary roller 36 is disposed at a position on the downstream side of the first main roller 33A, where it is held in contact with one main surface of the film F. The second auxiliary roller 39 is also made of metal. The second auxiliary roller 39 is disposed at a position on the upstream side of the second main roller 33B, where it is held in contact with the one main surface of the film F. Note that the second auxiliary roller 39 may be disposed at a position on the downstream side of the second main roller 33B, where it is held in contact with the one main surface of the film F.

The first coating deposition unit 20A is an evaporation source that is disposed facing the first main roller 33A for depositing a metal coating M1 (e.g., an aluminum coating) onto the one main surface of the film F supported on the first main roller 33A via an opening 14a of a partition plate 14.

The second coating deposition unit 20B is an evaporation source that is disposed facing the second main roller 33B for depositing a metal coating M2 (e.g., an aluminum coating) onto the other main surface of the film F supported the second main roller 33B via a opening 14b of the partition plate 14.

The first voltage supply circuit 40A includes a voltage source for applying a predetermined DC voltage between the first main roller 33A and the first auxiliary roller 36. The first voltage supply circuit 40A applies positive potential to the first auxiliary roller 36 and applies negative potential (ground potential) to the first main roller 33A, though not limited thereto. The positive potential may be applied to the first main roller 33A and the negative potential may be applied the first auxiliary roller 36. The magnitude of the predetermined DC voltage during coating deposition is 500 V, for example.

The second voltage supply circuit 40B includes a voltage source for applying a predetermined DC voltage between the second main roller 33B and the second auxiliary roller 39. The second voltage supply circuit 40B applies positive potential to the second auxiliary roller 39 and applies negative potential (ground potential) to the second main roller 33B. The magnitude of the predetermined DC voltage during coating deposition is 500 V, for example, though not limited thereto. The positive potential may be applied to the second main roller 33B and the negative potential may be applied to the second auxiliary roller 39.

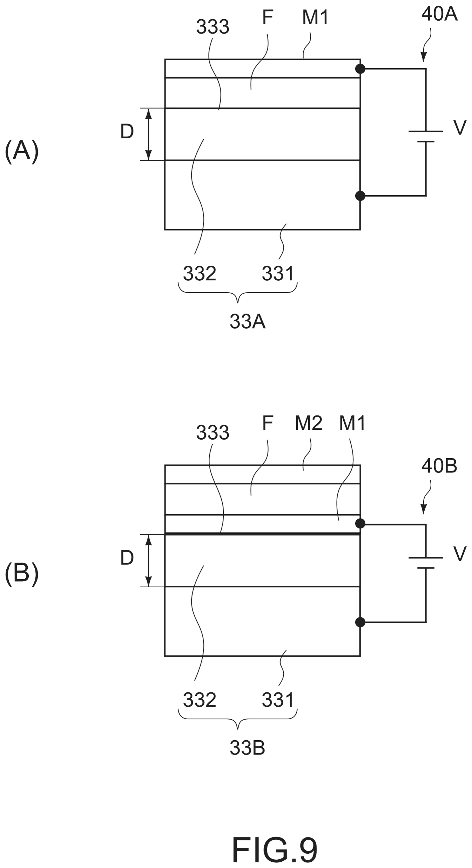

Fig. 9 is a schematic view of an electrostatic chuck mechanism configured between each of the first main roller 33A and the second main roller 33B and the film F. On the first main roller 33A, the film F is attracted onto the support surface 333 of the first main roller 33A by a DC voltage applied between the metal coating M1 formed on the one main surface of the film F by the first coating deposition unit 20A and the base part 331 of the first main roller 33A.

On the other hand, on the second main roller 33B, the film F is attracted onto the support surface 333 of the second main roller 33B by a DC voltage applied between the metal coating M1 formed on one main surface thereof and the base part 331 of the second main roller 33B.

The first neutralization unit 50A is for suppressing electrification of the film F or electrification (peeling electrification) of the first main roller 33A, which occurs when the film F is peeled from the first main roller 33A. The first neutralization unit 50A is configured to be capable of radiating charged particles for neutralization to the film F or the first main roller 33A. In this embodiment, the first neutralization unit 50A is constituted by an ion irradiator that is disposed directly above the first main roller 33A and radiates positive ions, e.g., argon ions, to a non-coating deposition surface (other main surface) of the film F, which is peeled from the first main roller 33A, though not limited thereto. The neutralization unit 50A may be configured to radiate charged particles for neutralization directly to a partial region of the outer circumferential surface of the first main roller 33A, around which the film F is not wound.

The second neutralization unit 50B is for suppressing electrification of the film F or electrification (peeling electrification) of the second main roller 33B, which occurs when the film F is peeled from the second main roller 33B. The second neutralization unit 50B is configured to be capable of radiating charged particles for neutralization to the film F or the second main roller 33B. In this embodiment, the second neutralization unit 50B is constituted by an ion irradiator that is disposed directly above the second main roller 33B and radiates positive ions, e.g., argon ions, to a non-coating deposition surface (other main surface) of the film F, which is peeled from the second main roller 33B, though not limited thereto. The neutralization unit 50B may be configured to radiate charged particles for neutralization directly to a partial region of the outer circumferential surface of the second main roller 33B, around which the film F is not wound.

Also in the vacuum treatment apparatus 200 according to this embodiment configured in the above-mentioned manner, actions and effects similar to those of the first embodiment can be obtained. That is, the adhesive force between the film F and the support surface 333 of the main rollers 33A and 33B increases. This can achieve both attractive force and dielectric strength. Moreover, the increase in the adhesive force between the film F and the support surface 333 also increases the heat transfer efficiency therebetween. This can suppress thermal deformation of the film F.

Moreover, in this embodiment, the metal coating M1 is formed on the one main surface of the film F on the first main roller M1, and then the metal coating M2 is formed on the other main surface of the film F on the second main roller 33B. Accordingly, the both surfaces of the film F can be consecutively deposited inside the same vacuum chamber 10.

Hereinabove, the embodiments of the present invention have been described. However, the present invention is not limited only to those embodiments, and various modifications can be made as a matter of course.

For example, in the above-mentioned embodiments, the roll-to-roll vacuum vapor deposition apparatus has been described as an example of the vacuum treatment apparatus, though not limited thereto. For example, a roll-to-roll sputtering apparatus or etching apparatus may be employed as the vacuum treatment apparatus.

Moreover, in the above-mentioned embodiments, the roll-to-roll vacuum treatment apparatus employing a long resin film as an example of the base has been described, though not limited thereto. The present invention can also be applied to a single-wafer vacuum treatment apparatus using a plate-like substrate, such as a semiconductor wafer or glass substrate, as the base. In this case, the support corresponds to a stage that supports the plate-like substrate and the present invention may be applied to an electrostatic chuck mechanism therefor.

In addition, in the above-mentioned first embodiment, a DC voltage is applied between the main roller 33 and the second auxiliary roller 35 disposed on the downstream side of the main roller 33, though not limited thereto. For example, the film F with the metal coating M deposited thereon is set to the feed roller 31 and the same or different metal coating is further deposited on the metal coating M, a DC voltage may be applied between the main roller 33 and the first auxiliary roller 34 disposed on the upstream side of the main roller 33. Also in this case, actions and effects similar to those of the first embodiment can be obtained.

### Reference Signs List

- 10: vacuum chamber
- 20, 20A, 20B: coating deposition unit
- 30: film conveying part
- 31: feed roller
- 32: take-up roller
- 33: main roller (conveyance roller, support)
- 35, 36, 39: auxiliary roller
- 40, 40A, 40B: voltage supply circuit
- 50, 50A, 50B: neutralization unit
- 331: base part
- 332: surface layer
- 333: support surface
- F: film (base)

## Claims

1. A vacuum treatment apparatus, comprising:
a vacuum chamber;
a support including
a base part that is disposed inside the vacuum chamber and constituted by a conductor and
a surface layer that is constituted by a dielectric and covers a surface of the base part, the surface layer including a support surface that electrostatically attracts a base that is a treatment target; and
a surface treatment means that treats a surface of the base attracted to the support surface, wherein
the surface layer has a thickness of 200 µm or more and 800 µm or less, and
the support surface has surface roughness (Ra) of 0.06 µm or more and 0.2 µm or less and a profile bearing length ratio at a section level of 50% or more is 90% or more.

2. The vacuum treatment apparatus according to claim 1, wherein
the surface layer has a thickness of 400 µm or more and 600 µm or less.

3. The vacuum treatment apparatus according to claim 1, wherein
the base is a long film, and
the support is at least one conveyance roller that conveys the base with the base wound around the roller.

4. The vacuum treatment apparatus according to claim 1, wherein
the base is a semiconductor substrate or a glass substrate, and
the support is a stage on which the base is placed.

5. The vacuum treatment apparatus according to claim 3, further comprising
a first voltage supply circuit including
an auxiliary roller that is disposed on a downstream side or upstream side of the conveyance roller and is held in contact with one main surface of the base and
a voltage source for applying a direct-current (DC) voltage between the auxiliary roller and the conveyance roller, wherein
the surface treatment means includes a first coating deposition unit that vapor-deposits a conductive material on the one main surface of the base.

6. The vacuum treatment apparatus according to claim 3, further comprising
a second voltage supply circuit including
an auxiliary roller that is disposed on an upstream side or downstream side of the conveyance roller and is held in contact with one surface of the base on which a conductive material is deposited and
a voltage source for applying a direct-current (DC) voltage between the auxiliary roller and the conveyance roller, wherein
the surface treatment means includes a second coating deposition unit that vapor-deposits a conductive material on another main surface of the base.

7. The vacuum treatment apparatus according to claim 5 or 6, further comprising
a neutralization unit that irradiates the base or the conveyance roller with charged particles for neutralizing the base.

8. An electrostatic chuck, comprising:
a base part that is constituted by a conductor; and
a surface layer that is constituted by a dielectric, covers a surface of the base part, and includes a support surface that electrostatically attracts a base that is a treatment target, wherein
the surface layer has a thickness of 200 µm or more and 800 µm or less, and
the support surface has surface roughness (Ra) of 0.06 µm or more and 0.2 µm or less and a profile bearing length ratio at a section level of 50% or more is 90% or more.

9. A conveyance roller, comprising:
a rotatable tubular base part that is constituted by a conductor; and
a surface layer that is constituted by a dielectric, covers a surface of the base part, and includes a support surface that electrostatically attracts a long film that is a treatment target,
wherein
the surface layer has a thickness of 200 µm or more and 800 µm or less, and
the support surface has surface roughness (Ra) of 0.06 µm or more and 0.2 µm or less and a profile bearing length ratio at a section level of 50% or more is 90% or more.
